Europäisches Patentamt

European Patent Office

Office européen des brevets

(11) Numéro de publication : **0 526 269 A1**

# (12) DEMANDE DE BREVET EUROPEEN

(21) Numéro de dépôt : **92401766.8**

(51) Int. Cl.⁵ : **H05K 9/00**

(22) Date de dépôt : **24.06.92**

(30) Priorité : **28.06.91 FR 9108104**

(43) Date de publication de la demande :
**03.02.93 Bulletin 93/05**

(84) Etats contractants désignés :
**DE GB IT**

(71) Demandeur : **COMMISSARIAT A L'ENERGIE ATOMIQUE**
**31-33, rue de la Fédération**
**F-75015 Paris (FR)**

(71) Demandeur : **UNIVERSITE PIERRE ET MARIE CURIE PARIS VI**
**2-4, place Jussieu -Tour 12**
**F-75272 Paris Cédex 05 (FR)**

(72) Inventeur : **Mariotte, Frédéric, Résidence Rosier Bellevue**
**26, rue de l'Oustalot**
**F-33170 Gradignan (FR)**
Inventeur : **Fourrier-Lamer, Arlette**
**20, rue Romain Roland**
**F-93260 Les Lilas (FR)**
Inventeur : **Zouhdi, Said, c/o Mme Egonneau**
**89, rue Pierre Brossolette**
**F-91330 Yerres (FR)**

(74) Mandataire : **Mongrédien, André et al**
**c/o BREVATOME 25, rue de Ponthieu**
**F-75008 Paris (FR)**

(54) Ecran polariseur et absorbant présentant des motifs chiraux plans.

(57) Cet écran comprend un support (2) recouvert d'au moins un motif chiral (4) apte à absorber les micro-ondes, et à changer leur polarisation réalisé en matériau conducteur d'électricité ou diélectrique, ce motif chiral (4) présentant la forme soit d'au moins un tour de spirale soit d'au moins une boucle ouverte (6) se terminant par au moins un doigt (8), ce tour et cette boucle (6) étant disposés dans le plan du support (2) et la permittivité du support (2) étant différente de celle du matériau du motif (4).

FIG. 1A

EP 0 526 269 A1

Jouve, 18, rue Saint-Denis, 75001 PARIS

La présente invention a pour objet un écran présentant des motifs chiraux plans réalisés en matériau conducteur d'électricité ou diélectrique, ce système étant apte à absorber les ondes dans un grand domaine de longueurs d'ondes (ondes radios, micro-ondes, ondes millimétriques, infrarouges et visibles) et à modifier leur polarisation.

Il peut être utilisé comme revêtement d'une chambre anéchoïque (chambre sans écho) pour l'expérimentation ; comme filtre électromagnétique ou comme blindage électromagnétique utilisé notamment dans les domaines des télécommunications et de l'informatique (blindage de circuits complexes, d'ordinateurs, de télévisions, ...), dans les navires, dans les domaines aéronautiques ainsi que dans les aéroports.

De façon générale, cet écran est destiné à tout système nécessitant un changement de polarisation de l'onde électromagnétique et/ou son absorption.

Dans les aéroports se trouvant à proximité de grandes villes et entourés de grandes constructions, les ondes d'hyperfréquences émises et reçues par les tours de contrôle sont fortement perturbées. Aussi, le blindage électromagnétique des aéroports est essentiel afin de pouvoir diriger avec sûreté les avions sur les pistes d'atterrissage et d'envol. Actuellement, plusieurs grands aéroports internationaux sont concernés par ce problème.

Dans la suite du texte, on parlera de micro-ondes pour indiquer des ondes dont la longueur d'onde est supérieure au millimètre.

On connaît actuellement un certain nombre de matériaux absorbant les micro-ondes.

En particulier, on trouve actuellement dans le commerce des tuiles de ferrite absorbant les micro-ondes entre 100 et 1000 MHz, ayant une épaisseur de 5 à 15 mm et une densité surfacique de l'ordre de 20 à 30 kg/m$^2$, donc élevée. On trouve aussi des matériaux composites organiques chargés, tels que des caoutchoucs chargés avec des ferrites ou des métaux dont la fréquence d'utilisation varie de 5 à 15 GHz, dont l'épaisseur varie de 1 à 5 mm et dont la densité surfacique, élevée, varie de 2 à 15 kg/mm$^2$.

On connaît également d'après le document WO 90/03102 un matériau absorbant les micro-ondes et comprenant une matrice de base en polymère à l'intérieur de laquelle sont réparties de façon aléatoire, dans tout le volume, des inclusions chirales à trois dimensions, en forme de ressort, réalisées en métal ou en nylon, par exemple.

Comme autres matériaux absorbant les micro-ondes actuellement connus, on trouve des motifs pyramidaux ou des structures alvéolaires présentant une épaisseur de plusieurs dizaines de centimètres et une densité surfacique faible allant de 1 à 5 kg/mm$^2$. Ces derniers matériaux sont généralement utilisés pour équiper des chambres anéchoïdes en vue d'études expérimentales.

Quelles que soient la nature et l'application des matériaux absorbant les micro-ondes connus, le problème du poids et de l'encombrement se pose ; soit que les produits sont minces mais denses, soit qu'ils sont légers mais épais. Ces problèmes de poids et d'encombrement limitent considérablement les applications de ces matériaux absorbants, chaque structure ou configuration étant bien spécifique d'une application particulière. En outre, leur absorption des micro-ondes est généralement limitée à une faible gamme de longueur d'onde.

La présente invention a justement pour objet un écran absorbant des ondes électromagnétiques et/ou changeant leur polarisation ainsi que son procédé de fabrication, cet écran permettant notamment de remédier aux inconvénients ci-dessus.

De façon plus précise, l'invention a pour objet un écran absorbant les ondes électromagnétiques et/ou changeant leur polarisation comprenant un support recouvert d'au moins un motif chiral, plan, photogravé apte à absorber les micro-ondes, réalisé en matériau conducteur d'électricité ou diélectrique, ce motif ,chiral présentant la forme soit d'au moins un four de spirale soit d'au moins une boucle ouverte se terminant par au moins un doigt, ce tour et cette boucle étant disposés dans le plan du support et la permittivité diélectrique du support étant différente de celle du matériau du motif.

On considère comme motif chiral plan, tout objet plan présentant une capacité et une inductance localisées capables d'induire des moments dipolaires électrique et magnétique orientés respectivement dans les directions du champ électrique et magnétique.

Grâce à l'utilisation de motifs chiraux plans, on pourra réaliser l'écran sous forme de couches minces, de faible masse, pour absorber plus spécialement les micro-ondes et modifier leur polarisation dans un grand domaine de fréquences allant de 50 MHz à 300 GHz.

Parmi les matériaux conducteurs d'électricité, on utilisera de préférence les métaux, tels que l'or, l'argent, le palladium, le platine et avantageusement le cuivre.

Parmi les matériaux diélectriques, on pourra citer les céramiques (saphir, alumine, tétratitanate de baryum) ou les polymères organiques.

En particulier, le motif chiral présente la forme d'une boucle ouverte se terminant par deux doigts parallèles de longueurs différentes.

Il est toutefois possible de réaliser le motif sous forme d'une spirale plane, se terminant éventuellement

2

par un seul doigt.

Les dimensions de la boucle ou de la spirale (son épaisseur et son diamètre) ainsi que l'espacement entre deux boucles ou spirales, dans le cas d'utilisation de plusieurs boucles ou spirales, sont fonction de la longueur d'onde à absorber.

En réalisant les motifs chiraux selon la technique des circuits imprimés, on pourra obtenir des motifs allant de quelques microns à quelques dizaines de millimètres, en fonction de la longueur d'onde à absorber.

Selon une autre variante de réalisation, l'écran absorbant comprend un support comprenant un socle conducteur d'électricité et une couche substrat de permittivité diélectrique différente de celle du matériau du motif.

Comme couche substrat, on utilisera de préférence un matériau polymère et notamment un film de polyimide.

On peut également réaliser cet écran sous forme de multicouches. Un tel écran permet une adaptation d'impédance dans l'épaisseur de l'écran et permet d'augmenter ainsi sa bande d'absorption.

L'invention a également pour objet un procédé de fabrication de l'écran absorbant les ondes électromagnétiques et/ou changeant leur polarisation tel que décrit précédemment. Ce procédé se caractérise en ce qu'il comprend les étapes suivantes consistant à :

a) déposer sur un support, une couche d'un matériau conducteur d'électricité ou diélectrique,

b) déposer sur cette couche de matériau conducteur d'électricité ou diélectrique, une couche de résine photosensible,

c) insoler la résine photosensible à travers un masque définissant un motif chiral à réaliser dans le matériau, ce motif chiral présentant la forme soit d'au moins un tour de spirale soit d'au moins une boucle ouverte se terminant par au moins un doigt,

d) éliminer la résine non polymérisée,

e) éliminer le matériau non masqué,

f) éliminer la résine restante.

Ce procédé permet non seulement de réaliser des motifs chiraux plans, mais également de superposer plusieurs couches de ces motifs, ces derniers étant donc répartis dans l'épaisseur de l'écran de façon ordonnée.

Selon une autre variante de réalisation, on peut également déposer entre le support et les motifs en matériau conducteur d'électricité ou diélectrique, une couche substrat.

D'autres caractéristiques et avantages de l'invention ressortiront mieux de la description qui va suivre, donnée à titre illustratif et non limitatif, en référence aux figures annexées, dans lesquelles :

- les figures 1A et 1B représentent en perspective une partie de deux modes de réalisation de l'écran absorbant selon l'invention,

- les figures 2 et 3 illustrent le principe d'absorption des micro-ondes par l'écran absorbant selon l'invention,

- la figure 4 est un schéma illustrant un exemple de disposition des motifs chiraux de l'écran absorbant selon l'invention,

- les figures 5a à 5e sont des schémas représentant en perspective, les diverses étapes du procédé de fabrication d'un écran selon l'invention,

- la figure 6 représente un écran absorbant multicouche conforme à l'invention,

- les figures 7A et 7B représentent deux autres variantes de motifs chiraux de l'écran conforme à l'invention.

Comme illustré en figure 1a, l'écran absorbant les micro-ondes selon l'invention comprend un support 2 recouvert d'au moins un motif chiral 4, apte à absorber les micro-ondes et réalisé dans un matériau conducteur d'électricité ou diélectrique. Ce motif chiral 4 présente la forme de plusieurs boucles définissant une spirale plane ouverte 6 se terminant par un doigt 8. On notera que la permittivité diélectrique du support 2 doit être différente de celle du matériau du motif 4.

Ce support 2 comprend un socle conducteur d'électricité 10 et une couche substrat 12 présentant une permittivité diélectrique généralement inférieure à celle du matériau utilisé pour la réalisation du motif chiral 4. La présence de cette couche substrat 12 n'est pas obligatoire et l'on pourrait réaliser le motif chiral 4 directement sur le socle conducteur 10.

Le socle conducteur 10 peut être une plaque métallique, un textile de fibres de carbone, un film polymérique métallisé ou encore une peinture conductrice. Dans le cas de peinture et de textile, la rigidité de l'ensemble est due aux couches polymériques à base de polymère conducteur.

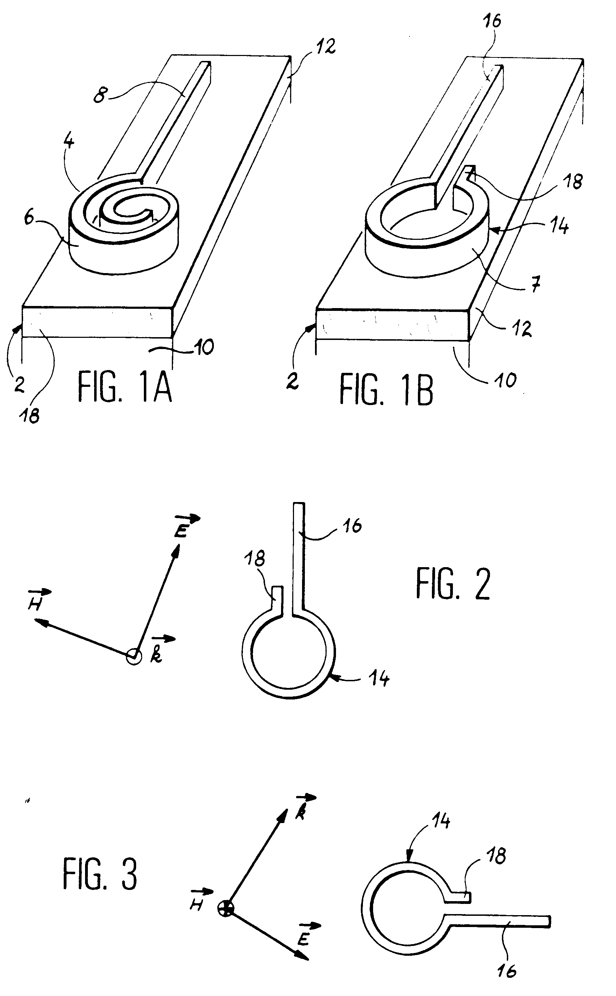

La figure 1b illustre une variante de réalisation de la forme du motif chiral 4. Dans ce cas, le motif chiral porte la référence 14. Ce motif 14 présente la forme d'une boucle ouverte 7 (plus précisément d'un anneau) se terminant par deux doigts parallèles 16 et 18 de longueur différente. Le doigt le plus long porte la référence 16 et le doigt le plus court porte la référence 18. On notera que dans ces deux cas les boucles 6, 7 sont disposées dans le plan du support 2.

On pourrait également prévoir d'autres motifs chiraux tels qu'une monoboucle ou une spirale mais dont les bords intérieur et extérieur de chaque boucle présentent en vue de dessus la forme d'un carré. Dans le cas où l'on a un seul doigt 8, celui-ci sera disposé soit dans le prolongement de l'extrémité de la boucle ou spirale, soit perpendiculairement à cette extrémité.

On utilisera de préférence comme couche substrat 12, un matériau polymère, par exemple un film de polyimide connu sous la marque déposée Kapton. Toutefois, on pourrait également utiliser des matériaux céramiques tels que l'alumine, le saphir ou la silice.

Le matériau conducteur d'électricité ou diélectrique formant le motif chiral 4, 14 est en particulier un métal choisi parmi les métaux nobles ou les métaux de transition et éventuellement leurs alliages. On utilisera de préférence le cuivre, toutefois l'or pourrait également convenir.

L'intérêt particulier de l'emploi de motifs chiraux 4 et 14 a été déterminé par une étude théorique.

Les éléments chiraux présentent une absence de symétrie et font tourner le plan de polarisation de la lumière polarisée mais également d'une manière plus générale les ondes électromagnétiques.

Premièrement, lorsqu'on applique un champ électromagnétique sur un élément chiral, on obtient l'équation suivante définissant le moment magnétique $\vec{M}$ :

$$\vec{M} = X_m (1/\mu_o)\vec{B} + X_{me}\vec{E}$$

dans laquelle $X_m$ et $X_{me}$ représentent respectivement la susceptibilité magnétique et la susceptibilité croisée magnétique et électrique, $\vec{B}$ représente l'induction magnétique, $\vec{E}$ le champ électrique et $\mu_o$ la perméabilité magnétique dans le vide.

Or, le champ magnétique

$$\vec{H} = (1/\mu_o)\vec{B} - \vec{M}$$

et $X_m = (\mu_r - 1)/\mu_r$ d'où l'on déduit que :

$$\vec{H} = (1/\mu)\vec{B} - X_{me}\vec{E} \qquad (1)$$

avec $\mu_r$ représentant la perméabilité magnétique relative et $\mu$ la perméabilité du matériau utilisé pour l'absorption.

Deuxièment, lorsqu'on applique un champ électromagnétique sur un élément chiral, on constate que la polarisabilité P d'un tel matériau s'exprime selon la formule :

$$\vec{P} = X_E \epsilon_o \vec{E} + X_{me}\vec{B}$$

dans laquelle $X_E$ rprésente la susceptibilité diélectrique et $\epsilon_o$ représente la permittivité diélectriques dans le vide.

Or, l'induction électrique $\vec{D}$ présente la formule suivante :

$$\vec{D} = \epsilon_o \vec{E} + \vec{P}$$

d'où l'on en déduit que :

$$\vec{D} = \epsilon\vec{E} + X_{me}\vec{B} \qquad (2)$$

en sachant que $\epsilon_r = 1 + X_e = \epsilon/\epsilon_o$

$\epsilon$ représentant la permittivité de l'élément chiral et $\epsilon_r$ la permittivité relative.

On va maintenant étudier le cas spécifique d'un élément chiral plan et l'intérêt d'un tel élément.

On décrit ci-après plus en détail, les deux cas extrêmes de réception d'une onde incidente électromagnétique transverse (TEM) sur un motif chiral plan à deux doigts, semblable à celui représenté en figure 1B.

Cas n°1 :

Ce cas est étudié en faisant référence à la figure 2.

Lorsque l'onde incidente transverse électromagnétique (TEM), a son vecteur d'onde $\vec{k}$ orthogonal à la surface de la boucle 14 et que le champ électrique $\vec{E}$ de cette onde est dans le plan du motif, l'élément chiral transforme l'onde TEM incidente en onde transverse électrique (TE).

Cas n° 2 :

Ce cas est étudié en faisant référence à la figure 3. Lorsque l'onde TEM, a son vecteur d'onde $\vec{k}$ parallèle au plan de la boucle et que le champ $\vec{H}$ de cette onde est perpendiculaire au plan, l'élément chiral transforme l'onde TEM incidente en onde transverse magnétique (TM).

Cas n°3 :

Dans le cas où l'onde incidente TEM est de vecteur $\vec{k}$ quelconque, les situations des cas 1 et 2 coexistent. L'onde incidente TEM sera transformée en une onde de composante ($\vec{E}$, $\vec{H}$).

Dans la pratique, les ondes incidentes pouvant venir de n'importe quelle direction, on réalise de préférence des écrans comportant plusieurs motifs chiraux 4 ou 14 dont les doigts sont orientés dans le plan mais de façon aléatoire.

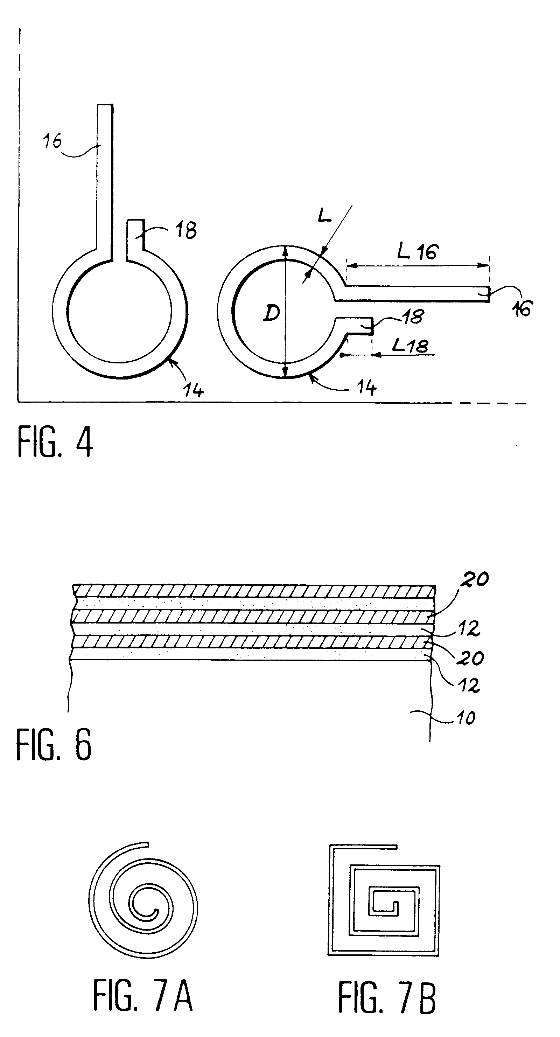

Dans le cas des chambres anéchoïdes où la direction des ondes est fixée, on peut orienter les motifs chiraux de façon que tous les doigts soient parallèles ou on peut alterner les motifs, comme illustré en figure 4, de façon que les doigts 16, 18 de deux motifs chiraux voisins soient perpendiculaires.

A titre d'exemple purement illustratif, (voir figure 4), le motif chiral 14 selon l'invention présente une largeur L d'environ 50 micromètre, le diamètre extérieur D de la boucle 4 est d'environ 500 micromètres, la longueur $L_{16}$ du doigt 16 est d'environ 550 micromètres et la longueur $L_{18}$ du doigt 18 est d'environ 50 micromètres. Il est destiné à absorber des ondes dont la fréquence est choisie dans une gamme variant de 8,2 à 12,4 GHz.

Comme illustré en figure 6, on peut réaliser un écran multicouche. On dispose alors sur le socle conducteur d'électricité 10, plusieurs couches 20 de plusieurs motifs 4 ou 14, empilées, séparées par des couches substrats 12.

On obtient ainsi une adaptation d'impédance dans l'épaisseur de l'écran, ce qui augmente encore sa bande "passante" (ou bande d'absorption).

L'invention concerne également un procédé de fabrication de l'écran absorbant les micro-ondes. Ce procédé consiste en la réalisation d'une succession d'étapes.

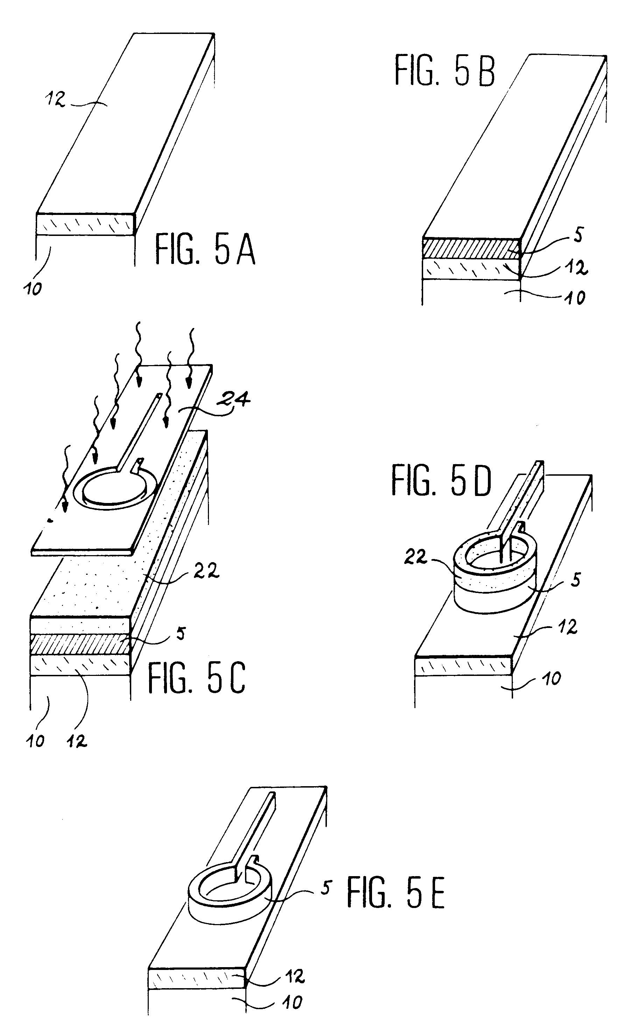

Premièrement, on nettoie un socle 10 formant support afin qu'il soit exempt de poussière et de tout autre matière étrangère pouvant provoquer des défauts de surface. Comme illustré en figure 5a, on dépose sur ce socle 10 au moins une couche substrat 12 de polymère, par exemple un film de polyimide connu sous la marque déposée KAPTON®. On dépose ensuite sur cette couche substrat 12 au moins une couche d'un matériau 5 conducteur d'électricité, notamment un métal présentant une permittivité diélectrique différente de celle de la couche substrat 12 et mieux supérieure à celle de la couche substrat, par exemple le cuivre (figure 5b).

L'ensemble formé du socle 10 recouvert de la couche substrat de polyimide 12 et de cuivre 5 est ensuite soumis à une opération de nettoyage du cuivre. On réalise une première étape de nettoyage mécanique en frottant le cuivre avec de la poudre ponce extra fine, de l'ordre de quelques microns. Cette poudre ponce est alliée à un détergent, c'est-à-dire un dégraissant, et à un désoxydant du cuivre. On immerge ensuite l'ensemble dans de l'alcool dénaturé afin de faciliter son séchage à l'air chaud filtré, à une température de 30°C. On peut alors observer la surface du cuivre 5 au microscope. Si celle-ci présente une strie ou un sillon, on pourra niveler d'une façon succincte la surface du cuivre par une attaque électrolytique dans une solution d'acide pyrophosphorique, avec une cathode en inox.

On dépose ensuite par centrifugation, une couche de résine photosensible 22 sur la couche de cuivre 5 (figure 5c). On choisira par exemple comme résine photosensible celle commercialisée sous la marque déposée "photoresist KPR®" de Kodak. En fonction de la vitesse de centrifugation, de la densité de la résine photosensible 22 et de la température, cette résine va s'étaler sur la plaque de cuivre 5 sur une certaine épaisseur. L'ensemble de ces opérations s'effectuera en salle blanche (exempte de poussière). On réalise ensuite une opération de séchage en étuve ventilée. Ce procédé est connu de l'homme de l'art et ne sera pas décrit plus en détail.

On insole ensuite la résine photosensible 22 à travers un masque 24 définissant le motif chiral, ici le motif 14, à réaliser dans le cuivre. La couche de résine photosensible 22 soumise aux ultraviolets, va polymériser et durcir. On immerge ensuite l'ensemble de l'écran dans une solution de révélateur, par exemple le révélateur Kodak (marque déposée). On élimine ensuite les parties de résine non polymérisées et on colore en bleu les parties polymérisées de façon à dissocier le cuivre nu des parties polymérisées. On peut alors contrôler la netteté du dessin au microscope et éventuellement repérer les défauts tels que les rayures dans la résine photosensible.

On grave alors le cuivre par éclatement de bulles de persulfate d'ammonium à travers une paroi poreuse. Pour ce faire, on dispose la plaque de polyimide cuivré protégée au niveau du dessin par la résine photosensible 22 durcie, face à un disque de pierre poreuse. Le persulfate d'ammonium amené sous pression avec de l'air comprimé passe à travers cette pierre poreuse et éclate à l'air libre. Les bulles de persulfate sont projetées contre le cuivre et attaquent celui-ci en continu jusqu'à atteindre le polyimide, en ne laissant en place que le cuivre 5 protégé par la résine 22 (figure 5d).

On contrôle ensuite au projecteur le profil après gravure, puis on élimine la résine polymérisée 22 et le motif chiral en cuivre 5 apparaît en relief sur la couche de polyimide (figure 5e).

D'autres motifs chiraux tels que ceux représentés sur les figures 7A et 7B peuvent être envisagés. Dans ces modes de réalisation, les spirales ne comportent pas de doigt.


## Revendications

1. Ecran absorbant et/ou changeant la polarisation des ondes électromagnétiques, caractérisé en ce qu'il comprend un support (2) recouvert d'au moins un motif chiral (4, 14) plan, photogravé. apte à absorber les micro-ondes, et à changer leur polarisation/ réalisé en matériau (5) conducteur d'électricité ou diélectrique, ce motif chiral (4, 14) présentant la forme soit d'au moins un tour de spirale soit d'au moins une boucle ouverte (6, 7) se terminant par au moins un doigt (8, 16, 18), ce tour et cette boucle (6, 7) étant disposés dans le plan du support (2) et la permittivité du support (2) étant différente de celle du matériau du motif (4, 14).

2. Ecran selon la revendication 1, caractérisé en ce que le motif chiral (14) présente la forme d'une boucle ouverte (6) se terminant par deux doigts parallèles (16, 18) de longueur différente.

3. Ecran absorbant selon la revendication 1 ou 2, caractérisé en ce que le support (2) comprend un socle conducteur d'électricité (10) et une couche substrat (12) de permittivité différente de celle du matériau du motif (4, 14).

4. Ecran absorbant selon la revendication 3, caractérisé en ce que la couche substrat (12) est un matériau polymère.

5. Ecran absorbant selon la revendication 4, caractérisé en ce que le matériau polymère est un film de polyimide.

6. Ecran absorbant selon l'une quelconque des revendications 1 à 5, caractérisé en ce que le matériau (5) du motif chiral (4, 14) est un métal.

7. Ecran absorbant selon la revendication 6, caractérisé en ce que le métal est le cuivre.

8. Ecran absorbant selon l'une quelconque des revendications précédentes, caractérisé en ce qu'il comporte plusieurs couches (20) de plusieurs motifs (4, 14) empilées, séparées par des couches substrats (12).

9. Procédé de fabrication d'un écran absorbant selon l'une quelconque des revendications 1 à 8, caractérisé en ce qu'il comprend les étapes suivantes consistant à :
    a) déposer sur un support (2) une couche d'un matériau (5) conducteur d'électricité ou diélectrique,
    b) déposer sur cette couche de matériau (5) conducteur d'électricité ou diélectrique une couche de résine photosensible (22),
    c) insoler la résine photosensible (22) à travers un masque (24) définissant un motif chiral (4, 14) à réaliser dans le matériau, ce motif chiral (4, 14) présentant la forme soit d'au moins un tour de spirale, soit d'au moins une boucle ouverte (6) se terminant par au moins un doigt (8, 16, 18),
    d) éliminer la résine (22) non polymérisée,
    e) éliminer le matériau (5) non masqué,

f) éliminer la résine (22) restante.

10. Procédé selon la revendication 9, caractérisé en ce qu'il comprend les étapes suivantes consistant à :
a) déposer une couche substrat (12) sur un socle (10) de façon à former le support (2),
b) déposer une couche de matériau (5) sur la couche substrat (12),
c) déposer la couche de résine (22),
d) insoler la résine (22) à travers le masque (24),
e) éliminer la résine (22) non polymérisée,
f) éliminer le matériau (5) non masqué,
g) éliminer la résine (22) restante.

11. Procédé de fabrication d'un écran selon la revendication 10, caractérisé en ce qu'avant le dépôt de la couche substrat (12) sur le socle (10), on effectue au moins une étape de préparation de la surface dudit socle.

12. Procédé de fabrication d'un écran selon l'une quelconque des revendication 9 à 11, caractérisé en ce qu'avant de déposer la résine photosensible (22), on nettoie la surface du matériau (5) conducteur d'électricité ou diélectrique.

13. Procédé de fabrication d'un écran selon la revendication 10, caractérisé en ce que la couche substrat (12) est un film de polyimide.

14. Procédé de fabrication d'un écran selon l'une quelconque des revendications 9 à 13, caractérisé en ce que le matériau (5) est le cuivre.

15. Procédé de fabrication d'un écran selon la revendication 14, caractérisé en ce que l'élimination du cuivre (5) non protégé par la résine photosensible (22) est réalisée par éclatement de bulles de persulfate d'ammonium à travers une paroi poreuse.

FIG. 1A

FIG. 1B

FIG. 2

FIG. 3

FIG. 4

FIG. 6

FIG. 7A

FIG. 7B

FIG. 5 A

FIG. 5 B

FIG. 5 C

FIG. 5 D

FIG. 5 E

Office européen
des brevets

# RAPPORT DE RECHERCHE EUROPEENNE

Numero de la demande

EP 92 40 1766

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | WO-A-9 003 102 (THE PENNSYLVANIA STATE UNIVERSITY) <br> * en entier * <br> --- | 1-15 | H 05 K 9/00 |
| Y | US-A-4 411 982 (SHIBUYA ET AL.) <br> * en entier * <br> --- | 1-15 | |
| A | JOURNAL OF WAVE MATERIAL INTERACTION vol. 2, no. 1, janvier 1987, PHILADELPHIA, PENNSYLVANIA, US pages 71 - 81 V.K. VARADAN ET AL. 'On the possibility of designing anti-reflection coatings using chiral composites' <br> * en entier * <br> ----- | 1 | |

**DOMAINES TECHNIQUES RECHERCHES (Int. Cl.5)**

H 05 K

Le présent rapport a été établi pour toutes les revendications

| Lieu de la recherche | Date d'achèvement de la recherche | Examinateur |
|---|---|---|
| LA HAYE | 22-10-1992 | TOUSSAINT F.M.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)